# EUROPÄISCHE PATENTANMELDUNG

(11) **EP 1 521 309 A1**
(43) Veröffentlichungstag der Anmeldung: **06.04.2005**
(21) Anmeldenummer: 03022098.2
(22) Anmeldetag: 02.10.2003
(51) Int. Cl.: H01L 31/0352, H01L 31/042, H01L 31/05

(54) **Serienverschaltung von Solarzellen mit integrierten Halbleiterkörpern, Verfahren zur Herstellung und Photovoltaikmodul mit Serienverschaltung**

(71) Anmelder: Scheuten Glasgroep, 5900 AA Venlo (NL)
(72) Erfinder: Geyer, Volker, 41372 Niederkrüchten (DE); Kaas, Patrick, 5632 MN Eindhoven (NL)
(74) Vertreter: Jostarndt, Hans-Dieter, Dr. Dipl.-Phys.

(57) **Zusammenfassung**

Die Erfindung betrifft ein Verfahren zur Herstellung einer Serienverschaltung von Solarzellen mit integrierten Halbleiterkörpern, eine damit hergestellte Serienverschaltung und ein Photovoltaikmodul, welche wenigstens eine Serienverschaltung umfasst.

Das Verfahren zeichnet sich dadurch aus, dass in eine isolierende Trägerschicht leitende Körper (20) und Halbleiterkörper (30) nach einem Muster eingebracht werden, wobei das Muster wenigstens eine Trennlinie (21) aus leitenden Körpern vorsieht. Die Bereiche neben den Leiterkörpern (20) werden mit kugel- oder kornförmigen Halbleiterkörpern (30) bestückt. Teile der Halbleiterkörper werden abgetragen und die Trägerschicht auf dieser Seite mit einer Rückkontaktschicht (50) beschichtet. So wird beispielsweise die Rückkontaktschicht eines Halbeiterkörpers freigelegt und mit der Rückkontaktschicht (50) der Solarzelle in Kontakt gebracht. Die andere Seite der Trägerschicht (10) wird mit einer Vorderkontaktschicht versehen. Durch Einbringen von jeweils zwei Trennschnitten entlang einer Reihe von Leiterkörpern kann der Stromfluss durch die gebildeten Solarzellen mit den integrierten Halbleiterkörpern so geführt werden, dass die Zellenbereiche zwischen den Leiterkörperreihen in Serie verschaltet sind. Einzelne Serienverschaltungen können schindelartig untereinander kontaktiert werden, so dass jeweils ein Rückkontakt in Verbindung mit einen Vorderkontakt steht.

## Beschreibung

Die Erfindung betrifft eine Serienverschaltung von Solarzellen mit integrierten Halbleiterkörpern.

Die Erfindung betrifft ferner ein Verfahren zur Herstellung einer Serienverschaltung von Solarzellen mit integrierten Halbleiterkörpern.

Die Erfindung betrifft ferner ein Photovoltaikmodul mit Serienverschaltung von Solarzellen.

In der Industrie besteht ein zunehmender Bedarf nach Verfahren zur Herstellung von Serienverschaltungen von Solarellen. Insbesondere auf dem speziellen Gebiet der Photovoltaik, bei dem zur Bildung eines p/n-Übergangs Halbleiterpartikel in ein Schichtsystem eingebracht werden, ist es sinnvoll, Bereiche aus Dünnschichten und Halbleiterpartikeln zu Zellen oder Arrays zusammenzufassen und diese Zellen in Serie zu verschalten, um höhere Spannungen abgreifen zu können. Das Problem der Serienverschaltung von Solarzellen mit eingebrachten Halbleiterpartikeln ist jedoch noch nicht zufriedenstellend gelöst.

Die Deutsche Patentanmeldung DE 100 52 914 A1 beschreibt beispielsweise ein Halbleiterbauelementesystem, bei dem eine Halbleiterstruktur aus Schichten mit eingebrachten Halbleiterpartikeln an vorgegebenen Stellen komplett durchstoßen wird. In diese Löcher mit einer Größe von wenigen Hundert µm werden isolierte Leiterstifte eingebracht, die an der Vorderseite fest mit einer leitfähigen Schicht verbunden werden. Die Reihenverschaltung der Arrays wird über die Anbringung von Leiterbrücken vorgenommen, wonach die Arrays am Ende des Vorgangs voneinander elektrisch getrennt werden. Die Trennstellen werden mit isolierenden und gleichzeitig klebenden Materialien vergossen.

In einem anderen Ausführungsbeispiel, das ebenfalls in der Deutschen Offenlegungsschrift DE 100 52 914 A1 beschrieben wird, wird bei der Herstellung des Halbleiterbauelementesystems so verfahren, dass abwechselnd auf definierten Flächen unterschiedliche Halbleiterbauelementtypen (n- und p-Material) aufgebracht werden. So bilden sich auf einer Seite eines Systems abwechselnd Bereiche mit positiven oder negativen Elektroden aus, die durch eine integrierte Verschaltung in Reihe verbunden werden können. Dazu werden die Elektrodenschichten abwechselnd oben und unten unterbrochen. Die Aufbringung von unterschiedlichen Halbleiterbauelementtypen zur Erzeugung einer Fläche mit unterschiedlichen Elektroden stellt jedoch ein aufwändiges Verfahren dar.

Aufgabe der Erfindung ist es daher, ein Verfahren zur Herstellung von Serienverschaltungen von Solarzellen mit integrierten Halbleiterkörpern bereitzustellen, das mit wenigen und einfachen Verfahrensschritten durchführbar ist.

Ferner ist es Aufgabe der Erfindung, eine Serienverschaltung von Solarzellen mit integrierten Halbleiterkörpern bereitzustellen, die durch wenige und einfach durchzuführende Verfahrensschritte hergestellt ist.

Aufgabe der Erfindung ist es ferner, ein Photovoltaikmodul mit serienverschalteten Solarzellen bereitzustellen.

Erfindungsgemäß wird diese Aufgabe durch die Merkmale der Ansprüche 1, 22 und 26 gelöst. Vorteilhafte Weiterbildungen der Erfindung sind den Unteransprüchen zu entnehmen.

Bei dem erfindungsgemäßen Verfahren zur Herstellung einer Serienverschaltung von Solarzellen mit integrierten Halbleiterkörpern werden ein oder mehrere leitende Körper und kugel- oder kornförmige Halbleiterkörper nach einem Muster in eine isolierende Trägerschicht eingebracht, wobei die Körper wenigstens auf einer Seite der Trägerschicht aus der Oberfläche der Trägerschicht herausragen, und das Muster wenigstens eine durchgehende Trennlinie der Breite B aus leitenden Körpern vorsieht. Die Bereiche neben einer Trennlinie oder zwischen mehreren Linien werden mit Halbleiterkörpern bestückt.

In einem besonders bevorzugten Ausführungsbeispiel der Erfindung sieht das Muster in der Trägerschicht vor, dass zwischen einer Trennlinie und einem Bereich, der mit Halbleiterkörpern bestückt ist, ein Abstand liegt, so dass sich neben einer Trennlinie ein dünner Streifen ergibt, in welchen Trennschnitte eingebracht werden können, ohne dass die leitenden Körper oder die Halbleiterkörper dabei berührt und ebenfalls durchtrennt werden. Es ist auch möglich, keinen Abstand vorzusehen, so dass die Trennschnitte so eingebracht werden, dass dadurch Teile der leitenden Körper und/oder der Halbleiterkörper abgetrennt werden.

Bei den in die Trägerschicht eingebrachten Körpern kann es sich beispielsweise um Körper aus Vollmaterial oder beschichtete Substratkerne handeln. Als leitende Körper können beispielsweise Partikel aus einem leitenden Material oder mit einem leitenden Material beschichtete Partikel zur Anwendung kommen. Bei dem leitenden Material handelt es sich in einem bevorzugten Ausführungsbeispiel der Erfindung um Kupfer. In einem weiteren besonders bevorzugten Ausführungsbeispiel der Erfindung werden als Halbleiterkörper Partikel aus I-III-VI-Verbindungshalbleitern oder mit I-III-VI-Verbindungshalbleitern beschichtete Substrate verwendet, so dass unter die Bezeichnung "Halbleiterkörper" jegliche Körper fallen können, bei denen ein Bestandteil ein Halbleitermaterial ist.

In einem weiteren Ausführungsbeispiel der Erfindung werden die leitenden Körper durch ein oder mehrere Bänder gebildet. Dies hat den Vorteil, dass eine durchgehende Trennlinie gebildet werden kann. Ferner hat es sich als zweckmäßig erwiesen, einen leitenden Körper in Form von Paste in die Trägerschicht einzubringen. Dies ist insbesondere von Vorteil, wenn es sich bei der Trägerschicht um eine Matrix mit Aussparungen für einzubringende Körper handelt. So kann die leitende Paste auf einer Seite der Matrix aufgebracht und durch die Aussparungen auf die andere Seite der Matrix gedrückt werden, so dass sich auf beiden Seiten eine leitende Trennlinie befindet, die durch die Trägerschicht hindurch kontaktiert sind.

Erfindungsgemäß werden Teile der Halbleiterkörper auf einer Seite der Trägerschicht abgetragen. Dies geschieht, um eine Fläche der Halbleiterkörper freizulegen, welche mit dem Rückkontakt der Solarzelle kontaktiert werden soll. Dabei handelt es sich vorzugsweise um eine Rückkontaktschicht, die auf dem Halbleiterkörper unterhalb einer Halbleiterschicht abgeschieden wurde, so dass ein Abtrag der Halbleiterschicht erforderlich ist. Ferner wird eine Rückkontaktschicht auf die Seite der Trägerschicht mit den abgetragenen Halbleiterkörpern und eine Vorderkontaktschicht auf die andere Seite der Trägerschicht aufgebracht. Die Vorderkontaktschicht und die Rückkontaktschicht bestehen aus einem leitfähigen Material.

Zur Herstellung einer Solarzelle können je nach angestrebter Ausführungsform weitere Funktionsschichten aufgebracht werden, zu denen beispielsweise eine Bufferschicht aus CdS, intrinsisches Zinkoxid und/oder eine TCO-Schicht zählen können. In einem weiteren besonders bevorzugten Ausführungsbeispiel der Erfindung umfassen die Halbleiterkörper neben einer Rückkontaktschicht und einer Halbleiterschicht weitere Funktionsschichten, zu denen ebenfalls eine Bufferschicht aus CdS, intrinisches Zinkoxid oder eine TCO-Schicht zählen können.

In einem weiteren Verfahrensschritt werden jeweils zwei Trennschnitte entlang einer Reihe aus leitenden Körpern eingebracht, wobei ein erster Trennschnitt in die Vorderkontaktschicht und ein zweiter Trennschnitt in die Rückkontaktschicht eingebracht wird. Die Trennschnitte liegen dabei auf unterschiedlichen Seiten der jeweiligen Trennlinie aus leitenden Körpern, und sie durchdringen die Rückkontaktschicht bis zu der Trägerschicht.

In einem besonders bevorzugten Ausführungsbeispiel der Erfindung ist die Reihe aus Leiterkörpern im Wesentlichen gerade und erstreckt sich zwischen zwei gegenüber liegenden Kanten der Trägerschicht. Das Muster aus Trennlinien aus Leiterkörpern und dazwischen liegenden Bereichen in Form von Solarzellen kann jedoch frei gewählt werden, so dass beispielsweise auch gebogene Trennlinien möglich sind.

Die Leiter- und Halbleiterkörper können beispielsweise aufgestreut und danach eingedrückt werden. In einem besonders bevorzugten Ausführungsbeispiel der Erfindung werden die kugel- oder kornförmigen Körper in eine Matrix einer Trägerschicht eingebracht, welche vorgefertigte Aussparungen für die Körper aufweist. Die Körper können beispielsweise durch einen Erwärmungs- und/oder Pressvorgang in die Trägerschicht eingebracht werden. Zur Aufbringung der Vorderkontakt- und Rückkontaktschicht eignen sich verschiedene PVD- und/oder CVD-Verfahren oder andere Verfahren, die der Art der jeweiligen Schicht angepasst sind. Wird beispielsweise ein leitfähiger Kleber verwendet, hat sich das Aufpinseln oder Aufschmieren des Klebers als zweckmäßig erwiesen.

Mit dem erfindungsgemäßen Verfahren lässt sich eine Serienverschaltung erzeugen, bei welcher der Strom durch einen Bereich aus Halbleiterkörpern der Vorderkontaktschicht in die Trennlinie aus leitenden Körpern fließt. Der Weiterfluss des Stromes aus den Leiterkörpern in den nächsten Bereich aus Halbleiterkörpern der Vorderkontaktschicht wird jedoch durch einen ersten Trennschnitt unterbunden, so dass der Strom über die Leiterkörper in den Rückkontakt fließt. Der Stromfluss durch den Rückkontakt wird dabei durch einen zweiten Trennschnitt im Rückkontakt unterbunden. So werden zwischen den Trennlinien aus leitenden Körpern Bereiche gebildet, die als Solarzelle wirken und die miteinander in Serie verschaltet sind.

Die erfindungsgemäße Serienverschaltung von Solarzellen mit integrierten Halbleiterkörpern weist dazu wenigstens eine isolierende Trägerschicht auf, in die leitende Körper und kugel- oder kornförmige Halbleiterkörper nach einem Muster eingebracht sind, wobei die Körper auf wenigstens einer Seite der Trägerschicht aus der Schicht herausragen. Das Muster sieht wenigstens eine Trennlinie der Breite B aus leitenden Körpern vor, während die Bereiche neben einer Reihe oder zwischen mehreren Reihen mit Halbleiterkörpern bestückt sind.

Die Serienverschaltung weist ferner eine Vorderkontaktschicht und eine Rückkontaktschicht auf, wobei die Rückkontaktschicht auf der Seite der Trägerschicht liegt, auf welcher Teile der Halbleiterkörper abgetragen wurden. Jeweils zwei Trennschnitte sind entlang einer Trennlinie aus leitenden Körpern eingebracht, wobei ein erster Trennschnitt in die Vorderkontaktschicht und ein zweiter Trennschnitt in die Rückkontaktschicht eingebracht ist. Die Trennschnitte liegen auf unterschiedlichen Seiten der Reihe aus Leiterkörpern und durchdringen die Rückkontaktschicht bis zu der Trägerschicht.

Wird die Serienverschaltung mit dem erfindungsgemäßen Verfahren hergestellt, weist wenigstens einer der kugel- oder kornförmigen Halbleiterkörper auf der Seite der Trägerschicht, auf welcher die Rückkontaktschicht der Solarzelle angeordnet ist, eine Fläche auf, über die ein direkter Kontakt zwischen der Rückkontaktschicht der Solarzelle und einer Rückkontaktschicht des Halbleiterkörpers erfolgt. Handelt es sich bei den Halbleiterkörpern beispielsweise um mit einem Rückkontakt und einem Halbleiter beschichtete Substrate, werden die Halbleiterkörper soweit entschichtet, dass eine Fläche aus Rückkontakt entstanden ist, die mit der Rückkontaktschicht der Solarzelle kontaktiert werden kann. Weisen die Halbleiterkörper neben einer Rückkontaktschicht und einer Halbleiterschicht weiter Funktionsschichten auf, wurden diese ebenfalls so abgetragen, dass eine Fläche aus Rückkontakt frei liegt.

Der wesentliche Vorteil der erfindungsgemäßen Serienverschaltung von Solarzellen und dem zugehörigen Verfahren zur Herstellung liegt in der einfachen Ausführung der Verschaltung der Solarzellenbereiche, welche nur wenige Bearbeitungsschritte erfordert. Die erforderlichen leitenden Körper können in verschiedenen Formen und auf unterschiedliche Weisen eingebracht werden und die Einbringung der Trennschnitte stellt ebenfalls einen einfachen Verfahrensschritt dar.

Werden kugel- oder kornförmige Körper verwendet, können diese mit dem gleichen Verfahren wie die Halbleiterkörper eingebracht werden, so dass dafür keine zusätzlichen Verfahren oder Vorrichtungen entwickelt und angewendet werden müssen. Wird beispielsweise eine Paste als leitender Körper verwendet, die auf eine Trägermatrix mit Aussparungen aufgebracht wird, lassen sich auf einfache Weise zwei über die Trägerschicht verbundene Trennlinien erzeugen. Ferner ist der zusätzliche Materialaufwand gering, da lediglich leitende Körper eingebracht werden müssen. Die eingebrachten Trennschnitte stellen dabei keine Beeinträchtigung der gesamten Anordnung dar, da die Schwächung der Gesamtstruktur sehr gering ist.

Weitere Vorteile, Besonderheiten und zweckmäßige Weiterbildungen der Erfindung ergeben sich aus den Unteransprüchen und der nachfolgenden Darstellung bevorzugter Ausführungsbeispiele anhand der Abbildungen.

Von den Abbildungen zeigt:
- Fig. 1: in den Abbildungen (a) - (c) die Einbettung von kugelförmigen Halbleiter- und Leiterpartikeln in eine Trägerschicht;
- Fig. 2: in den Abbildungen (a) - (c) den Aufbau von Vorder- und Rückkontaktschichten; und
- Fig. 3: in den Abbildungen (a) - (b) die erfindungsgemäße Serienverschaltung von Solarzellen mit integrierten Halbleiterpartikeln;
- Fig. 4: ein besonders bevorzugtes Ausführungsbeispiel einer schindelartigen Verschaltung mehrerer Serienverschaltungen.

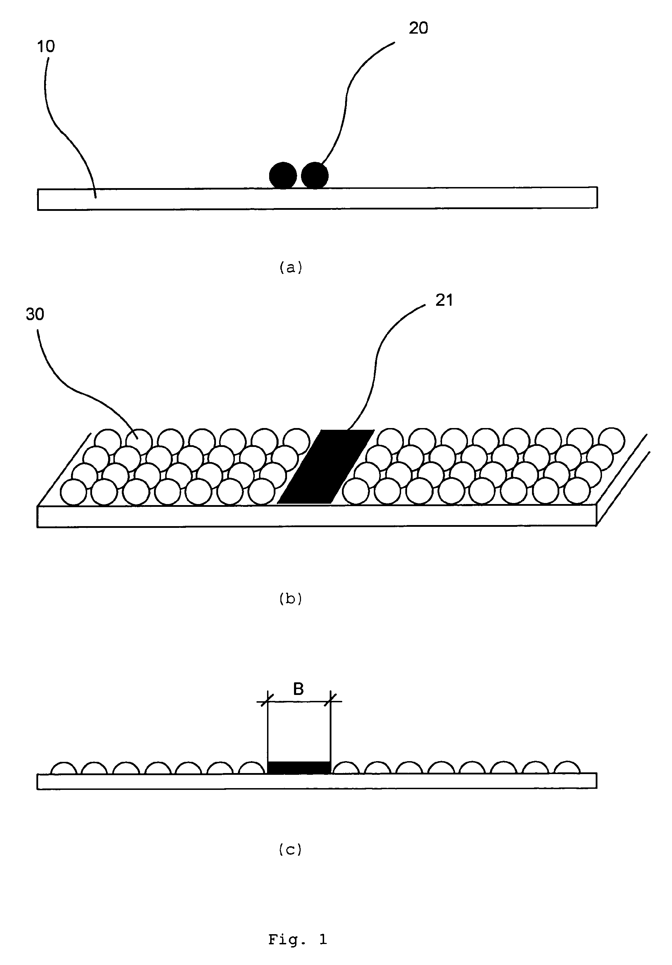

In den Abbildungen (a) - (c) der Fig. 1 ist die Einbringung von kugel- oder kornförmigen leitenden Körpern 20 und Halbleiterkörpern 30 in eine isolierende Trägerschicht 10 dargestellt. Dabei hat es sich als zweckmäßig erwiesen, als Trägerschicht eine flexible Folie zu verwenden. Die Trägerschicht besteht vorzugsweise aus einem thermoplastischen Material, in welche die leitenden Körper eingedrückt werden können. Besonders zweckmäßig hat sich Polymer erwiesen, bei dem es sich beispielsweise um ein Polymer aus der Gruppe der Epoxide, Polycarbonate, Polyester, Polyurethane, Polyacryle und/oder Polyimide handeln kann.

Bei den eingebetteten Körpern handelt es sich vorzugsweise um kugel- oder kornförmige Partikel mit leitenden oder halbleitenden Eigenschaften. Neben der reinen Kugelform können die Körper auch unregelmäßige Formen wie die von Körnern jeglicher Kontur annehmen. Dazu zählen beispielsweise auch Würfel, Quader oder Pyramiden. Als Leiterkörper 20 können daher Kugeln oder Körner aus leitenden Materialien wie Kupfer eingesetzt werden. In einem weiteren besonders bevorzugten Ausführungsbeispiel der Erfindung werden die leitenden Körper in Form von Bändern oder einer Paste eingebracht, welche die Form einer Trennlinie bilden.

Die Halbleiterkörper bestehen vollständig oder zum Teil aus geeigneten Halbleitermaterialien der Photovoltaik. In einer besonders bevorzugten Ausführungsform der Erfindung sind die Halbleitermaterialien aus der Klasse der I-III-VI-Verbindungshalbleiter, zu denen beispielsweise Kupferindiumdiselenid, Kupferindiumdisulfid, Kupferindiumgalliumdiselenid oder Kupferindiumgalliumdiseleniddisulfid zählen. In einem anderen Ausführungsbeispiel der Erfindung bestehen die Halbleiterkörper aus Siliziumhalbleitern. Dabei kann es sich um Halbleiter aus Vollmaterial oder um mit Halbleitermaterialien beschichtete Substratkerne handeln.

Die leitenden Körper und die Halbleiterkörper werden so in die Trägerschicht 10 eingebracht, dass sie wenigstens auf einer Seite der Trägerschicht aus der Oberfläche der Schicht herausragen. Die Körper können dazu beispielsweise durch Streuen, Stäuben und/oder Drucken aufgebracht und danach eingedrückt werden. Zum Eindrücken der Körper in die Trägerschicht kann diese beispielsweise erwärmt werden. Die Körper können beispielsweise mit einem Hilfsmittel zu einem gewünschten Muster angeordnet und so auf oder in der Trägerschicht platziert werden.

In einem besonders bevorzugten Ausführungsbeispiel der Erfindung werden die Körper in eine vorgefertigte Matrix einer Trägerschicht eingebracht, in der sich Aussparungen befinden, in welche die jeweiligen Körper eingefügt werden. Zur Befestigung der Körper an der Trägerschicht kann ein Erwärmungs- und/oder Pressvorgang durchgeführt werden. Wird beispielsweise eine Paste als leitfähiger Körper verwendet, kann die Paste auf gewünschte Bereiche der Matrix aufgebracht und in die dortigen Aussparungen gedrückt werden. Auf der Rückseite der Trägerschicht kann die Paste verstrichen werden, so dass sich auf beiden Seiten der isolierenden Trägerschicht eine Trennlinie bildet, welche durch die Aussparungen miteinander verbunden sind.

Die leitenden Körper werden nach einem Muster in die Trägerschicht eingebracht, das wenigstens eine im Wesentlichen gerade Trennlinie einer bestimmten Breite B aus leitenden Körpern 20 vorsieht. Dass die Reihe im Wesentlichen gerade ist, bedeutet in diesem Zusammenhang, dass auch geringfügige Abweichungen von einer Geraden umfasst sind. Soll für bestimmte Anwendungen eine geometrisch andere Abgrenzung zwischen einzelnen Solarzellen erfolgen, kann ein anderer Verlauf der Reihen aus Leiterkörpern wie beispielsweise bogenförmige Trennlinien gewählt werden.

Vorzugsweise erstreckt sich die Trennlinie aus Leiterkörpern zwischen zwei gegenüber liegenden Kanten der Trägerschicht 10. Die Breite der Reihen aus Leiterkörpern liegt vorzugsweise in der Größenordnung von B = 10µm-3mm und ist je nach Abmessung der verwendeten Leiterkörper beispielsweise durch einen oder mehrere Leiterkörper gegeben. In einem besonders bevorzugten Ausführungsbeispiel der Erfindung liegt die Breite der Trennlinien zwischen 10µm-30µm. Werden als leitende Körper kugel- oder kornförmige Partikel verwendet, richtet sich die Breite der Trennlinien nach dem Durchmesser der verwendeten Partikel. Die Breite der Trennlinien kann somit auch in der Größenordnung von einem oder mehreren Durchmessern einer leitenden Kugel, insbesondere zwischen 10-500µm, liegen.

Je nach gewünschter Breite einer zu verschaltenden Solarzelle wird eine Trägerschicht durch mehrere Reihen aus Leiterkörpern in entsprechende Bereiche aufgeteilt. Die Bereiche neben einer Trennlinie oder zwischen mehreren Trennlinien werden mit Halbleiterkörpern bestückt. Die Breite einer so begrenzten Solarzelle liegt vorzugsweise in der Größenordnung von 1mm-3cm. In einem besonders bevorzugten Ausführungsbeispiel der Erfindung liegt die Breite einer Solarzelle zwischen 3-5mm. Die Breite einer Trägerschicht mit einer so gebildeten Serienverschaltung liegt vorzugsweise in der Größenordnung von 5-30cm, wobei es sich als besonders vorteilhaft erwiesen hat, bandförmige Module aus mehreren serienverschalteten Solarzellen auszubilden, die vorzugsweise eine Breite von etwa 10cm aufweisen.

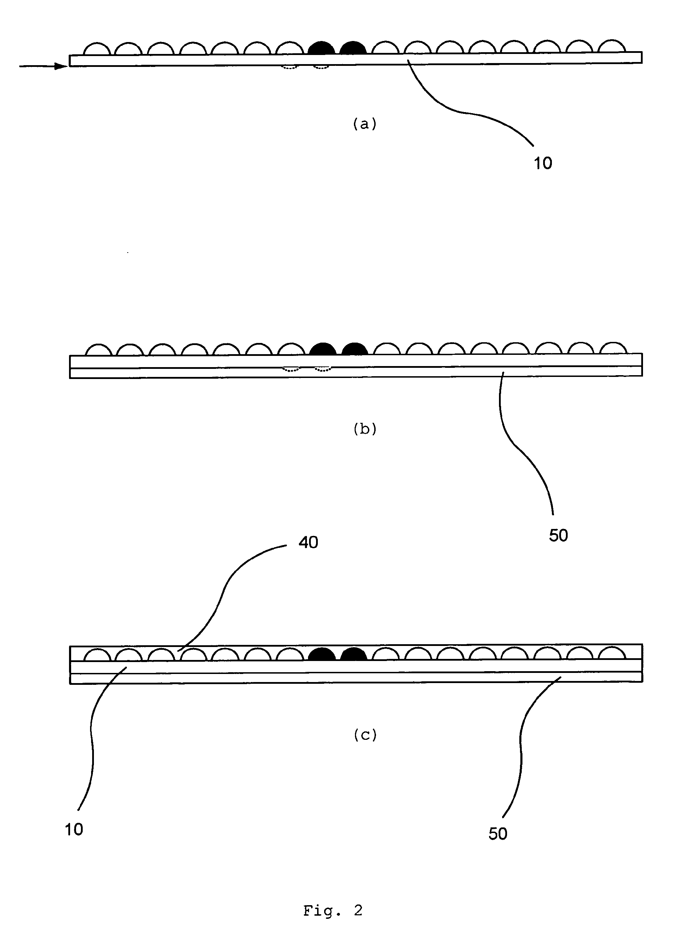

Den Abbildungen (a) - (c) der Fig. 2 ist die Bildung des Schichtaufbaus zur Herstellung einer Solarzelle mit integrierten Halbleiterkörpern zu entnehmen. In einem besonders bevorzugten Ausführungsbeispiel der Erfindung wird als erster Schritt Material der Trägerschicht 10 auf einer Seite abgetragen. Diese Seite wird bis zu einer Schichtdicke abgetragen, bei der Teile der eingebrachten Körper mit abgetragen werden. Die mit abgetragenen Bereiche der Körper sind in Abbildung (a) durch die verbleibenden gestrichelten Umrisse zweier Leiter- und Halbleiterkörper dargestellt. Der Abtrag der Trägerschicht kann jedoch auch zu anderen Zeitpunkten erfolgen, die vor der Aufbringung eines späteren Rückkontakts 50 auf dieser Seite liegen.

In einem anderen Ausführungsbeispiel der Erfindung ragen die Halbleiterkörper nach der Einbringung auf einer Seite der Trägerschicht so weit heraus, dass Teile davon abgetragen werden können, ohne dass ein gleichzeitiger Abtrag der Trägerschicht erforderlich ist. Der Abtrag der leitenden Körper, der Halbleiterkörper und/oder der Trägerschicht kann beispielsweise durch mechanische Verfahren wie Schleifen, Polieren, chemische oder nasschemische Verfahren (Prozesse) wie Ätzen, Photolitographie oder thermischen Energieeintrag z.B. über das Lasern und oder Bestrahlen mit Licht geeigneter Wellenlänge/Wellenlängenbereichs oder aber andere thermische Verfahren erfolgen.

Das Maß des Abtrags hängt vorrangig von den verwendeten Halbleiterkörpern ab. Werden beispielsweise kugel- oder kornförmige Substratkerne eingesetzt, die wenigstens mit einer Rückkontaktschicht und einer Halbleiterschicht beschichtet sind, erfolgt ein Abtrag bis zur Freilegung der Rückkontaktschicht des Partikels, um den Kontakt zum Rückkontakt der Solarzelle herzustellen. In einer besonders vorteilhaften Ausführungsform der Erfindung handelt es sich bei den Halbleiterkörpern um Glassubstratkerne, die mit einem Rückkontakt aus Molybdän und einem Halbleiter beschichtet sind. In diesem Fall wird ein Abtrag der Trägerschicht bis zu einer Schichtdicke durchgeführt, in welcher die Molybdänschicht der Körper freigelegt ist.

Dabei ist der Abtrag ferner davon abhängig, ob sich alle Halbleiterkörper gleich tief in der Trägerschicht befinden. Sind die Halbleiterkörper unterschiedlich tief eingebettet oder variiert die Größe der Körper, besteht die Möglichkeit, dass nicht alle Halbleiterkörper exakt bis zu ihrer Rückkontaktschicht entschichtet werden.

In einem weiteren Verfahrensschritt wird eine Rückkontaktschicht 50 auf die Seite der Trägerschicht 10 aufgebracht, auf der wenigstens Teile der Halbleiterkörper abgetragen wurden. Als Material für diesen Rückkontakt werden leitende Stoffe wie Metalle eingesetzt. Es können auch TCOs (Transparent Conductive Oxide) oder Stoffe aus diversen Polymerklassen verwendet werden. Besonders geeignet sind beispielsweise Epoxidharze, Polyurethane, und/oder Polyimide, die mit geeigneten leitfähigen Partikeln wie Kohlenstoff, Indium, Nickel, Molybdän, Eisen, Nickelchrom, Silber, Aluminium und/oder entsprechenden Legierungen bzw. Oxiden versehen sind. Eine weitere Möglichkeit stellen intrinsische leitfähige Polymere dar. Dazu zählen beispielsweise Polymere aus der Gruppe der PANis. Der Rückkontakt kann mit PVD-Verfahren wie dem Sputtern und Aufdampfen oder CVD-Verfahren wie PE-CVD oder MO-CVD oder aber auch auf eine andere, dem Rückkontaktmaterial angepasste Art und Weise hergestellt werden.

Im einem weiteren Verfahrensschritt wird eine leitende Vorderkontaktschicht 40 auf der Seite der Trägerschicht abgeschieden, auf der keine Bearbeitung der Körper erfolgte. Auch dies kann mit PVD- , CVD-Verfahren oder anderen, an das Vorderkontaktmaterial angepasste, Verfahren erfolgen. Als Material des Vorderkontakts können beispielsweise diverse TCOs (Transparent Conductive Oxides) (z.B. Aluminium dotiertes Zinkoxid (ZnO:Al) (auch AZO genannt), Indiumzinnoxid (ITO) oder Fluor dotiertes Zinnoxid (SnO₂:F) eingesetzt werden. Es hat sich als zweckmäßig erwiesen, einen transparenten Vorderkontakt einzusetzen, dessen Transmission vorzugsweise dem jeweiligen Halbleiter angepasst ist.

Vor und/oder nach der Abscheidung eines Vorder- und/oder Rückkontaktes können weitere Funktionsschichten abgeschieden werden. Dazu zählen beispielsweise eine Bufferschicht aus CdS, intrinsisches Zinkoxid oder eine weitere TCO-Schicht. In einem besonders bevorzugten Ausführungsbeispiel der Erfindung werden diese Funktionsschichten bereits auf den verwendeten Halbleiterkörpern abgeschieden, so dass eine erneute Abscheidung zur Herstellung einer Solarzelle gegebenenfalls nicht mehr erforderlich ist.

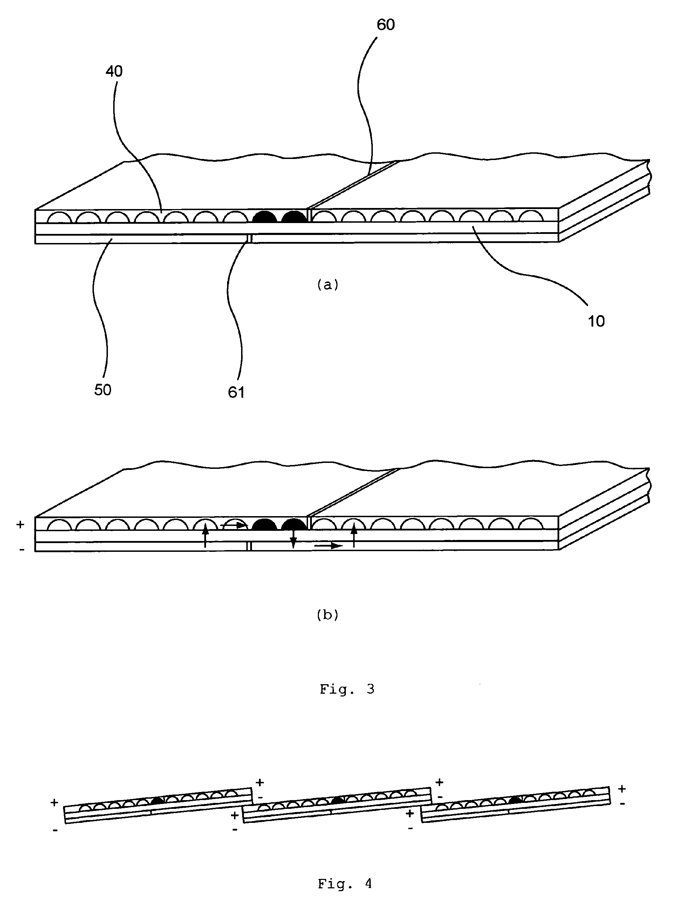

Als weiterer wesentlicher Verfahrensschritt werden jeweils zwei Trennschnitte 60 und 61 entlang einer Reihe aus leitenden Körpern eingebracht, wie es in der Abbildung (a) der Fig. 3 dargestellt ist. Ein Trennschnitt 60 wird dabei in die Vorderkontaktschicht 40 und ein Trennschnitt 61 in die Rückkontaktschicht eingebracht wird, wobei die Trennschnitte auf unterschiedlichen Seiten der Reihe aus leitenden Körpern 20 liegen. Die Trennschnitte können durch Verfahren wie Schneiden, Ritzen, thermischen Energieeintrag wie z.B. beim Laserschnitt oder photolithographische Prozesse eingebracht werden.

In einem besonders bevorzugten Ausführungsbeispiel der Erfindung werden die erzeugten Trennschnitte mit einem isolierenden Material aufgefüllt, um eine möglichst ebene Oberfläche der Solarzellenverschaltung zu erreichen. Dieser Schritt ist jedoch optional, da die erforderliche Tiefe der Trennschnitte 60;61 aufgrund der dünnen Vorder- und Rückkontaktschichten im µm-Bereich sehr gering ist.

Ist das Verfahren abgeschlossen, so dass alle Abscheidungsund Trennschritte durchgeführt sind, stellen die resultierenden Schichten mit den integrierten Halbleiterkörpern eine Serienverschaltung von Solarzellen dar, die in einem Photovoltaikmodul eingesetzt werden können. Ein Photovoltaikmodul kann je nach Ausführungsform eine oder mehrere Serienverschaltungen umfassen. Der resultierende Stromverlauf ist in Fig. 3 in der Abbildung (b) durch einen Pfeilverlauf dargestellt. In dem dargestellten Ausführungsbeispiel liegt der negative Vorderkontakt oben, während der positive Rückkontakt unten liegt. Der Strom fließt über die Halbleiterkörper 30 im Vorderkontakt in die leitenden Körper 20 und von da in den Rückkontakt 50, da der weitere Stromfluss durch den ersten Trennschnitt 60 unterbunden ist. Der Stromfluss durch den Rückkontakt 50 wird durch den zweiten Trennschnitt 61 unterbunden.

In einem besonders bevorzugten Ausführungsbeispiel der Erfindung wird ein derartige Serienverschaltung mit wenigstens einer weiteren entsprechenden Serienverschaltung zu einem größeren Modul verbunden. Dies geschieht beispielsweise dadurch, dass die einzelnen Serienverschaltungen bandförmig mit einer Breite in der Größenordnung von 5-30cm ausgebildet sind und die so gebildeten Submodule an den Rändern schindelartig übereinander gelegt werden. Dies ist in Fig. 4 dargestellt. So kommt ein Rückkontakt auf einem Vorderkontakt zu liegen und die einzelnen Module sind wiederum in Serie verschaltet. Die Kontaktierung zwischen jeweiliger Vorder- und Rückkontaktschicht kann beispielsweise über einen leitfähigen Kleber wie Silber-Epoxid erfolgen.

### Bezugszeichenliste:

- 10: Trägerschicht, Folie
- 20: leitende Körper, Leiterkörper
- 21: Trennlinie
- 30: Halbleiterkörper, kugel-/kornförmig
- 40: Vorderkontaktschicht
- 50: Rückkontaktschicht
- 60, 61: Trennschnitte

## Patentansprüche

1. Verfahren zur Herstellung einer Serienverschaltung von Solarzellen mit integrierten Halbleiterkörpern, **gekennzeichnet durch** folgende Merkmale:
- Einbringen von einem oder mehreren leitenden Körpern (20) in eine isolierende Trägerschicht (10) nach einem Muster wobei die leitenden Körper (20) wenigstens auf einer Seite der Trägerschicht aus der Oberfläche der Trägerschicht herausragen, und das Muster wenigstens eine Trennlinie (21) der Breite B vorsieht, die aus einem oder mehreren leitenden Körpern (20) gebildet wird;
- Einbringen von mehreren kugel- oder kornförmigen Halbleiterkörpern (30) in die isolierende Trägerschicht (10) nach einem Muster, wobei die Halbleiterkörper (30) wenigstens auf einer Seite der Trägerschicht aus der Oberfläche der Trägerschicht herausragen, und das Muster vorsieht, dass die Bereiche neben einer oder zwischen mehreren Trennlinien (21) aus leitenden Körpern (20) mit Halbleiterkörpern (30) bestückt werden;
- Abtragen von Teilen der Halbleiterkörper (30) auf einer Seite der Trägerschicht (10);
- Aufbringen einer leitenden Rückkontaktschicht (50) auf die Seite der Trägerschicht (10), auf welcher Teile der Halbleiterkörper (30) abgetragen wurden;
- Aufbringen einer leitenden Vorderkontaktschicht (40) auf die Seite der Trägerschicht (10, auf der keine Halbleiterkörper abgetragen wurden;
- Einbringen von jeweils zwei Trennschnitten (60;61) entlang einer Trennlinie (21) aus leitenden Körpern (20), wobei ein erster Trennschnitt (60) in die Vorderkontaktschicht (40) und ein zweiter Trennschnitt (61) in die Rückkontaktschicht eingebracht wird, die Trennschnitte auf unterschiedlichen Seiten der jeweiligen Trennlinie (21) liegen, und die Trennschnitte (60;61) die Rückkontaktschicht (50) bis zu der Trägerschicht (10) durchdringen.

2. Verfahren nach Anspruch 1, **dadurch gekennzeichnet, dass** das Muster vorsieht, dass zwischen einer Trennlinie (21) aus leitenden Körpern (20) und einem neben der Trennlinie (21) liegenden Bereich, der mit Halbleiterkörpern (30) bestückt ist, ein Abstand liegt.

3. Verfahren nach einem oder beiden der Ansprüche 1 und 2, **dadurch gekennzeichnet, dass** die kugel- oder kornförmigen Halbleiterkörper (30) aus Substratkernen bestehen, die wenigstens mit einer Rückkontaktschicht und einer darüber angeordneten Halbleiterschicht beschichtet sind.

4. Verfahren nach Anspruch 3, **dadurch gekennzeichnet, dass** die kugel- oder kornförmigen Halbleiterkörper (30) weitere Funktionsschichten aufweisen.

5. Verfahren nach Anspruch 4, **dadurch gekennzeichnet, dass** die kugel- oder kornförmigen Halbleiterkörper (30) eine Bufferschicht aus CdS aufweisen.

6. Verfahren nach einem oder beiden der Ansprüche 4 und 5, **dadurch gekennzeichnet, dass** die kugel- oder kornförmigen Halbleiterkörper (30) eine Schicht aus intrinsischem Zinkoxid aufweisen.

7. Verfahren nach einem oder mehreren der Ansprüche 4 bis 6, **dadurch gekennzeichnet, dass** die kugeloder kornförmigen Halbleiterkörper (30) eine Schicht aus einem TCO (Transparent Conductive Oxide) aufweisen.

8. Verfahren nach einem oder mehreren der Ansprüche 3 bis 7, **dadurch gekennzeichnet, dass** Teile der Halbleiterkörper (30) soweit abgetragen werden, dass eine Rückkontaktschicht der Halbleiterkörper (30) frei gelegt ist.

9. Verfahren nach einem oder mehreren der vorangegangen Ansprüche, **dadurch gekennzeichnet, dass** neben dem Abtragen von Teilen der Halbleiterkörper (30) Teile der leitenden Körper (20) abgetragen werden.

10. Verfahren nach einem oder mehreren der vorangegangen Ansprüche, **dadurch gekennzeichnet, dass** neben dem Abtragen von Teilen der Halbleiterkörper (30) ein Teil der Trägerschicht (10) abgetragen wird.

11. Verfahren nach einem oder mehreren der vorangegangen Ansprüche, **dadurch gekennzeichnet, dass** neben der Vorderkontaktschicht (40) und der Rückkontaktschicht (50) weitere Funktionsschichten abgeschieden werden.

12. Verfahren nach einem oder mehreren der vorangegangen Ansprüche, **dadurch gekennzeichnet, dass** die leitenden Körper (20) und/oder die Halbleiterkörper (30) durch Streuen, Stäuben und/oder Drucken auf die Trägerschicht (10) aufgebracht und danach in die Trägerschicht eingebracht werden.

13. Verfahren nach einem oder mehreren der vorangegangen Ansprüche, **dadurch gekennzeichnet, dass** mehrere leitende Körper (20) in Form von kugel- oder kornförmigen Partikeln in die Trägerschicht (10) eingebracht werden.

14. Verfahren nach einem oder mehreren der vorangegangen Ansprüche, **dadurch gekennzeichnet, dass** ein oder mehrere leitende Körper (20) in Form von Bändern in die Trägerschicht (10) eingebracht werden.

15. Verfahren nach einem oder mehreren der vorangegangen Ansprüche, **dadurch gekennzeichnet, dass** ein oder mehrere leitende Körper (20) in Form einer Paste in die Trägerschicht (10) eingebracht werden.

16. Verfahren nach einem oder mehreren der vorangegangenen Ansprüche, **dadurch gekennzeichnet, dass** die leitenden Körper (20) und/oder die Halbleiterkörper (30) durch ein Hilfsmittel zu einem Muster angeordnet werden, und die Körper (20;30) mit dem Hilfsmittel auf und/oder in der Trägerschicht platziert werden.

17. Verfahren nach einem oder mehreren der vorangegangenen Ansprüche, **dadurch gekennzeichnet, dass** die Trägerschicht (10) eine Matrix mit Aussparungen ist, in welche die Körper (20;30) eingebracht werden.

18. Verfahren nach einem oder mehreren der vorangegangenen Ansprüche, **dadurch gekennzeichnet, dass** die Körper (20;30) durch einen Erwärmungs- und/oder Pressvorgang in die Trägerschicht (10) eingebracht werden.

19. Verfahren nach einem oder mehreren der vorangegangenen Ansprüche, **dadurch gekennzeichnet, dass** die Trennlinie (21) aus leitenden Körpern (20) im Wesentlichen gerade ist.

20. Verfahren nach einem oder mehreren der vorangegangenen Ansprüche, **dadurch gekennzeichnet, dass** sich eine Trennlinie (21) aus leitenden Körpern (20) zwischen zwei gegenüber liegenden Kanten der Trägerschicht (10) erstreckt.

21. Verfahren nach einem oder mehreren der vorangegangenen Ansprüche, **dadurch gekennzeichnet, dass** das Abtragen der Körper (20;30) und/oder der Trägerschicht (10) durch Schleifen, Polieren, Ätzen, thermischen Energieeintrag und/oder photolithographische Prozesse erfolgt.

22. Verfahren nach einem oder mehreren der vorangegangenen Ansprüche, **dadurch gekennzeichnet, dass** die Rückkontaktschicht (50) und die Vorderkontaktschicht (40) durch PVD-Verfahren, CVD-Verfahren oder andere auf die Art der jeweiligen Schicht abgestimmte Verfahren abgeschieden werden.

23. Verfahren nach einem oder mehreren der vorangegangenen Ansprüche, **dadurch gekennzeichnet, dass** die Trennschnitte (60;61) durch Verfahren wie Schneiden, Ritzen, Ätzen, thermischen Energieeintrag oder photolithographische Prozesse eingebracht werden.

24. Verfahren nach einem oder mehreren der vorangegangenen Ansprüche, **dadurch gekennzeichnet, dass** die Breite einer Trennlinie (21) in der Größenordnung von B = 10µm-3mm, insbesondere zwischen 10µm-500µm, liegt.

25. Verfahren nach einem oder mehreren der vorangegangenen Ansprüche, **dadurch gekennzeichnet, dass** der Abstand zwischen zwei Trennlinien (21) in der Größenordnung von 1mm-3cm, insbesondere zwischen 3mm-5mm, liegt.

26. Serienverschaltung von Solarzellen mit integrierten Halbleiterkörpern, **dadurch gekennzeichnet, dass** die Serienverschaltung wenigstens folgende Merkmale aufweist:
- eine isolierende Trägerschicht (10), in welche ein oder mehrere leitende Körper (20) nach einem Muster eingebracht sind, wobei die leitenden Körper (20) wenigstens auf einer Seite der Trägerschicht aus der Oberfläche der Trägerschicht herausragen, und das Muster wenigstens eine Trennlinie (21) der Breite B vorsieht, die aus einem oder mehreren leitenden Körpern (20) gebildet sind;
- mehrere kugel- oder kornförmige Halbleiterkörper (30) in der isolierenden Trägerschicht (10), wobei die Halbleiterkörper (30) wenigstens auf einer Seite der Trägerschicht aus der Oberfläche der Trägerschicht herausragen und ein Muster bilden, in dem die Bereiche neben einer oder zwischen mehreren Trennlinien (21) mit Halbleiterkörpern (30) bestückt sind;
- eine leitende Vorderkontaktschicht (40) auf einer Seite der Trägerschicht (10), auf der die Körper (20;30) aus der Schicht herausragen;
- eine leitende Rückkontaktschicht (50) auf der Seite der Trägerschicht, die der Vorderkontaktschicht (40) gegenüber liegt;
- jeweils zwei Trennschnitte (60;61) entlang einer Reihe aus Leiterkörpern (20), wobei ein erster Trennschnitt (60) in die Vorderkontaktschicht (40) und ein zweiter Trennschnitt (61) in die Rückkontaktschicht eingebracht ist, die Trennschnitte auf unterschiedlichen Seiten der jeweiligen Reihe aus Leiterkörpern (20) liegen, und die Trennschnitte (60;61) die Rückkontaktschicht (50) bis zu der Trägerschicht (10) durchdringen.

27. Serienverschaltung nach Anspruch 26, **dadurch gekennzeichnet, dass** sie mit einem Verfahren nach einem oder mehreren der Ansprüche 1 bis 25 hergestellt ist.

28. Serienverschaltung nach einem oder beiden der Ansprüche 26 und 27, **dadurch gekennzeichnet, dass** das Muster vorsieht, dass zwischen einer Trennlinie (21) aus leitenden Körpern (20) und einem neben der Trennlinie (21) liegenden Bereich, der mit Halbleiterkörpern (30) bestückt ist, ein Abstand liegt.

29. Serienverschaltung nach einem oder mehreren der vorangegangenen Ansprüche 26 bis 28, **dadurch gekennzeichnet, dass** die Trägerschicht (10) aus einem thermoplastischen Material besteht.

30. Serienverschaltung nach einem oder mehreren der Ansprüche 26 bis 29, **dadurch gekennzeichnet, dass** die Trägerschicht (10) aus einem Polymer aus der Gruppe der Epoxide, Polyurethane, Polyacryle, Polycarbonate, Polyester und/oder Polyimide besteht.

31. Serienverschaltung nach einem oder mehreren der Ansprüche 26 bis 30, **dadurch gekennzeichnet, dass** ein leitender Körper (20) durch eine Paste gebildet wird.

32. Serienverschaltung nach einem oder mehreren der Ansprüche 26 bis 31, **dadurch gekennzeichnet, dass** ein leitender Körper (20) durch ein Band gebildet wird.

33. Serienverschaltung nach einem oder mehreren der Ansprüche 26 bis 32, **dadurch gekennzeichnet, dass** ein leitender Körper (20) durch einen kugel- oder kornförmigen Partikel gebildet wird.

34. Serienverschaltung nach Anspruch 33, **dadurch gekennzeichnet, dass** ein leitender Körper (20) in Vollmaterial aus einem leitenden Material besteht, oder ein leitender Körper (20) aus einem Substratkern besteht, der mit einem leitenden Material beschichtet ist.

35. Serienverschaltung nach Anspruch 34, **dadurch gekennzeichnet, dass** ein leitender Körper (20) in Vollmaterial aus Kupfer besteht.

36. Serienverschaltung nach Anspruch 34, **dadurch gekennzeichnet, dass** ein leitender Körper (20) aus einem Substratkern besteht, der mit Kupfer beschichtet ist.

37. Serienverschaltung nach einem oder mehreren der vorangegangenen Ansprüche 26 bis 36, **dadurch gekennzeichnet, dass** die Halbleiterkörper (30) in Vollmaterial aus einem Halbleitermaterial bestehen, oder die Halbleiterkörper (30) aus einem Substratkern bestehen, der mit einem Halbleitermaterial beschichtet ist.

38. Serienverschaltung nach Anspruch 37, **dadurch gekennzeichnet, dass** die Halbleiterkörper (30) in Vollmaterial aus einem I-III-VI-Verbindungshalbleiter bestehen.

39. Serienverschaltung nach Anspruch 37, **dadurch gekennzeichnet, dass** die Halbleiterkörper (30) aus einem kugel- oder kornförmigen Substratkern bestehen, der wenigstens mit einem I-III-VI-Verbindungshalbleiter beschichtet ist.

40. Serienverschaltung nach einem oder beiden der Ansprüche 38 und 39, **dadurch gekennzeichnet, dass** der I-III-VI-Verbindungshalbleiter aus der Gruppe der Kupferindiumdiselenide, Kupferindiumdisulfide, Kupferindiumgalliumdiselenide und Kupferindiumgalliumdiseleniddisulfide ist.

41. Serienverschaltung nach einem oder mehreren der vorangegangenen Ansprüche 26 bis 340, **dadurch gekennzeichnet, dass** die Halbleiterkörper (30) aus einem Substratkern bestehen, der wenigstens mit einer leitenden Rückkontaktschicht und einer Halbleiterschicht beschichtet ist.

42. Serienverschaltung nach Anspruch 41, **dadurch gekennzeichnet, dass** die Halbleiterkörper (30) aus einem Substratkern bestehen, der wenigstens mit einer leitenden Rückkontaktschicht aus Molybdän und einem I-III-VI-Verbindungshalbleiter beschichtet ist.

43. Serienverschaltung nach einem oder beiden der Ansprüche 41 und 42, **dadurch gekennzeichnet, dass** die Halbleiterkörper (30) weitere Funktionsschichten aufweisen.

44. Serienverschaltung nach Anspruch 43, **dadurch gekennzeichnet, dass** die Halbleiterkörper (30) eine Bufferschicht aus CdS aufweisen.

45. Serienverschaltung nach einem oder beiden der Ansprüche 43 und 44, **dadurch gekennzeichnet, dass** die Halbleiterkörper (30) eine Schicht aus intrinsischem Zinkoxid aufweisen.

46. Verfahren nach einem oder mehreren der Ansprüche 43 bis 45, **dadurch gekennzeichnet, dass** die Halbleiterkörper (30) eine Schicht aus einem TCO (Transparent Conductive Oxide) aufweisen.

47. Serienverschaltung nach einem oder mehreren der Ansprüche 41 bis 46, **dadurch gekennzeichnet, dass** wenigstens einer der Halbleiterkörper (30) auf der Seite der Trägerschicht (10), auf welcher die Rückkontaktschicht (50) der Solarzelle angeordnet ist, eine Fläche aufweist, über die ein direkter Kontakt zwischen der Rückkontaktschicht (50) der Solarzelle und der Rückkontaktschicht des Halbleiterkörpers (30) besteht.

48. Serienverschaltung nach einem oder mehreren der Ansprüche 226 bis 47, **dadurch gekennzeichnet, dass** die Trennlinie (21) aus leitenden Körpern (20) im Wesentlichen gerade ist.

49. Serienverschaltung nach einem oder mehreren der Ansprüche 26 bis 48, **dadurch gekennzeichnet, dass** sich die Trennlinie (21) aus leitenden Körpern (20) zwischen zwei gegenüber liegenden Kanten der Trägerschicht (10) erstreckt.

50. Serienverschaltung nach einem oder mehreren der Ansprüche 26 bis 49, **dadurch gekennzeichnet, dass** die Breite einer Trennlinie (21) in der Größenordnung von B = 10µm-3mm, insbesondere zwischen 10µm-500µm, liegt.

51. Serienverschaltung nach einem oder mehreren der Ansprüche 26 bis 50, **dadurch gekennzeichnet, dass** der Abstand zwischen zwei Trennlinien (21) in der Größenordnung von 1mm-3cm, insbesondere zwischen 3mm-5mm, liegt.

52. Serienverschaltung nach einem oder mehreren der Ansprüche 26 bis 51, **dadurch gekennzeichnet, dass** die Vorderkontaktschicht (40) aus einem leitenden Material besteht.

53. Serienverschaltung nach Anspruch 52, **dadurch gekennzeichnet, dass** die Vorderkontaktschicht (40) aus einem TCO (Transparent Conductive Oxide) besteht.

54. Serienverschaltung nach einem oder mehreren der Ansprüche 26 bis 53, **dadurch gekennzeichnet, dass** die Rückkontaktschicht (50) aus einem leitenden Material besteht.

55. Serienverschaltung nach Anspruch 54, **dadurch gekennzeichnet, dass** die Rückkontaktschicht (50) aus einem Metall, einem TCO (Transparent Conductive Oxide) oder einem leitfähigen Polymer besteht.

56. Serienverschaltung nach Anspruch 55, **dadurch gekennzeichnet, dass** die Rückkontaktschicht (50) aus einem Polymer aus der Gruppe der Epoxidharze, Polyurethane, und/oder Polyimide mit leitfähigen Partikeln einer Gruppe aus Kohlenstoff, Indium, Nickel, Silber, Molybdän, Eisen, Nickelchrom, Aluminium und/oder entsprechenden Legierungen bzw. Oxiden besteht.

57. Serienverschaltung nach Anspruch 54, **dadurch gekennzeichnet, dass** die Rückkontaktschicht (50) aus einem intrinsischen leitfähigen Polymer besteht.

58. Serienverschaltung nach Anspruch 57, **dadurch gekennzeichnet, dass** die Rückkontaktschicht (50) aus einem Polymer aus der Gruppe der PANis besteht.

59. Serienverschaltung nach einem oder mehreren der Ansprüche 26 bis 58, **dadurch gekennzeichnet, dass** die Serienverschaltung neben der Vorderkontaktschicht (40) und der Rückkontaktschicht (50) weitere Funktionsschichten aufweist.

60. Serienverschaltung nach einem oder mehreren der Ansprüche 26 bis 59, **dadurch gekennzeichnet, dass** die Trennschnitte (60;61) mit einem isolierenden Material aufgefüllt sind.

61. Serienverschaltung nach einem oder mehreren der Ansprüche 26 bis 60, **dadurch gekennzeichnet, dass** die Serienverschaltung bandförmig ist.

62. Serienverschaltung nach einem oder mehreren der Ansprüche 26 bis 61, **dadurch gekennzeichnet, dass** die Breite der Serienverschaltung in der Größenordnung von 5-30 cm, insbesondere bei etwa 10cm, liegt.

63. Serienverschaltung nach einem oder mehreren der Ansprüche 26 bis 562, **dadurch gekennzeichnet, dass** die Serienverschaltung so mit einer anderen Serienverschaltung verbunden ist, dass die Rückkontaktschicht (50) in Kontakt mit einer Vorderkontaktschicht der anderen Serienverschaltung steht.

64. Serienverschaltung nach Anspruch 563, **dadurch gekennzeichnet, dass** die Serienverschaltung schindelartig mit wenigstens einer anderen Serienverschaltung verbunden ist, wobei die Rückkontaktschicht (50) auf einer Vorderkontaktschicht oder die Vorderkontaktschicht (40) auf einer Rückkontaktschicht der anderen Serienverschaltung liegt.

65. Serienverschaltung nach einem oder beiden der Ansprüche 63 und 64, **dadurch gekennzeichnet, dass** die Rückkontaktschicht (50) mit einem leitfähigen Kleber mit einer Vorderkontaktschicht der anderen Serienverschaltung verbunden ist.

66. Photovoltaikmodul, **dadurch gekennzeichnet, dass** es eine Serienverschaltung nach einem oder mehreren der Ansprüche 26 bis 65 umfasst.
